Europäisches Patentamt

European Patent Office

Office européen des brevets

(19)

(11) Publication number: **0 075 924**
A2

(12) **EUROPEAN PATENT APPLICATION**

(21) Application number: 82108964.6

(22) Date of filing: 28.09.82

(51) Int. Cl.³: **H 01 L 27/14**

(30) Priority: 28.09.81 JP 153238/81

(43) Date of publication of application:
06.04.83 Bulletin 83/14

(84) Designated Contracting States:
DE FR GB

(71) Applicant: NIPPON ELECTRIC CO., LTD.
33-1, Shiba Gochome, Minato-ku
Tokyo, 108(JP)

(72) Inventor: Abe, Hiroshi c/o Nippon Electric co., Ltd.
33-1, Shiba Gochome Minato-ku
Tokyo(JP)

(74) Representative: Glawe, Delfs, Moll & Partner
Patentanwälte
Postfach 26 01 62 Liebherrstrasse 20
D-8000 München 26(DE)

(54) Solid state image pick-up device having a high resolution and a high sensitivity.

(57) A solid state image pick-up device having a high resolution and a high sensitivity has a photosensitive section which includes a semiconductor substrate of one conductivity type, a semiconductor layer of the other conductivity type formed on the semiconductor substrate, the semiconductor layer having a plurality of photosensitive element regions and a barrier region which is thinner than the photosensitive element regions, a semiconductor region of the one conductivity type formed on the barrier region, and an insulator film covering the photosensitive regions and the semiconductor region.

Fig.3c

## SOLID STATE IMAGE PICK-UP DEVICE HAVING
## A HIGH RESOLUTION AND A HIGH SENSITIVITY

### BACKGROUND OF THE INVENTION

The present invention relates to a solid state image pick-up device and more particularly to a structure of the solid state image pick-up device by which its resolution is improved without impairing its photosensitivity.

In recent years, a solid state image pick-up device has become more and more useful in that it is small in size, light in weight, highly reliable and has a long life time, in addition to the fact that it can be fabricated under the same process as a MOS integrated circuit. Solid state image pick-up devices are classified into two types; those of MOS type and those of a charge transfer device type (hereinafer called a CCD type). In either case, a principle aim of development currently being carried out is to obtain high resolution and high sensitivity. In order to attain a high resolution, it is only necessary to increase the number of photosensitive elements of the image pick-up device, but this causes an increase in the total area of the photosensitive elements on a semiconductor chip, resulting in lowering of the production yield. On the other hand, if the number of photosensitive elements is increased without increasing the total area, each photosensitive element must be made smaller, resulting in a decrease in sensitivity.

Therefore, it is a primary object of the present invention to provide a solid state image pick-up device having an improved resolution without lowering its sensitivity and without enlarging its area.

## SUMMARY OF THE INVENTION

According to the present invention, there is provided a solid state image pick-up device which includes a semiconductor substrate of one conductivity type, a semiconductor layer of the other conductivity type which is formed on the semiconductor substrate, an insulator layer dividing the semiconductor layer into a plurality of photosensitive element areas, and a region of the one conductivity type formed under the insulator layer, the semiconductor layer under the one conductivity type region being thinner than the semiconductor layer of the photosensitive element areas.

Accordingly, since the semiconductor layer under the one conductivity type region forms a potential profile functioning as a barrier against charges accumulated in the photosensitive element areas, charges produced in the region of the semiconductor layer under the one conductivity type region shift to and are accumulated in the photosensitive element areas. Therefore, the charges produced under the one conductivity type region are used to improve the sensitivity. In other words, the areas of the photosensitive elements can be made small to obtain a high resolution without sacrificing sensitivity.

## BRIEF DESCRIPTION OF THE DRAWINGS

The above and other objects and features of the invention will become more apparent from the following description taken in conjunction with the accompanying drawings, wherein:

Fig. 1 is a schematic plan view of a CCD image pick-up device;

Fig. 2 is a sectional view showing a part of a photosensitive section in accordance with a conventional CCD image pick-up device; and

Figs. 3(a), 3(b) and 3(c) are sectional views showing a procedure for manufacturing a CCD image pick-up device of the present invention.

## DETAILED DESCRIPTION OF THE INVENTION

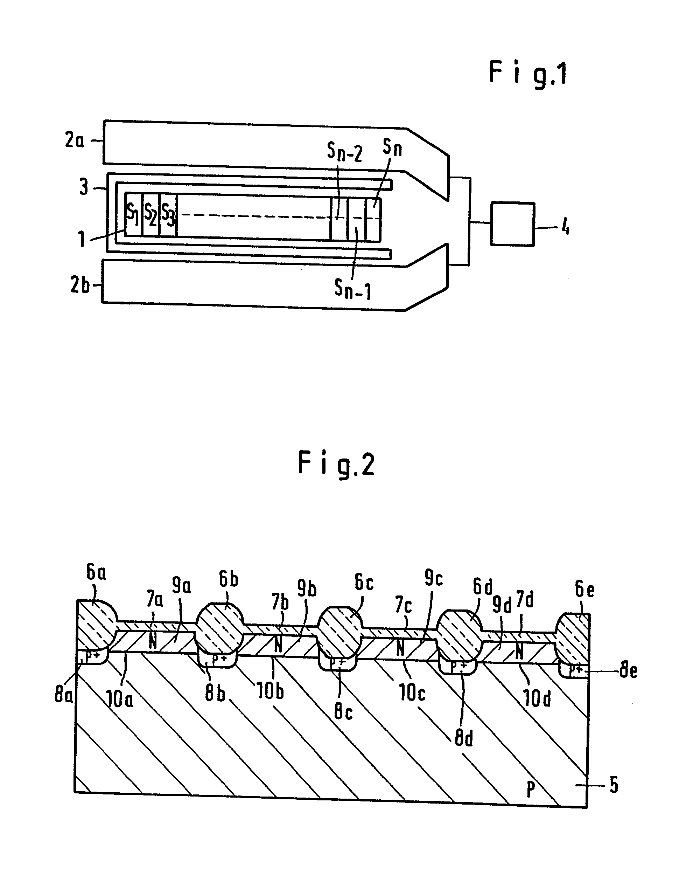

First of all, a solid-state image pick-up device will be generally explained as an example of CCD image pick-up device with reference to Fig. 1. A photosensitive section 1 including a plurality of photosensitive elements $S_1$, $S_2$, $S_3 \ldots S_{n-2}$, $S_{n-1}$ and $S_n$, a transfer gate electrode 3, two CCD shift registers 2a and 2b and an output circuit 4 are formed on a semiconductor substrate. The output circuit 4 may be formed on a different semiconductor substrate, if the CCD shift registers are arranged to externally output an electrical signal.

Photo carriers are produced and are accumulated in the photosensitive elements $S_1$, $S_2$, $S_3 \ldots S_{n-2}$, $S_{n-1}$ and $S_n$, when these elements are exposed to light. After a predetermined time period elapses during the exposure of the elements $S_1$, $S_2$, $S_3 \ldots S_{n-2}$, $S_{n-1}$ and $S_n$, the transfer gate electrode 3 opens to transfer the carriers accumulated in the respective photosensitive elements to the shift registers 2a and 2b. At this moment, for instance, the carriers in the even-numbered photosensitive elements $S_2$, $S_4 \ldots$ are transferred to the shift register 2a, while the carriers in the odd-numbered photosensitive elements $S_1$, $S_3 \ldots$ are transferred to the shift register 2b.

Thereafter, the transfer gate electrode 3 closes the gate, and the shift registers 2a and 2b begin to shift the carriers transferred from the respective photosensitive elements to the output circuit 4. The carriers shifted along the respective shift registers 2a and 2b are alternately input to the output circuit 4, which converts the amount of carriers into a voltage and outputs successive electrical signals corresponding to the charges in the respective photosensitive elements in sequence starting from the n-th element.

Next, a conventional structure of the photosensitive section 1 will be explained with reference to Fig. 2 which is a part-sectional view along the line connecting respective centers of photosensitive elements $S_1$, $S_2$, $S_3 \ldots S_{n-2}$, $S_{n-1}$ and $S_n$. Each photosensitive element corresponds to one of N-type regions 9a, 9b, 9c and 9d which are disposed on a P-type semiconductor substrate 5. The N-type regions 9a, 9b, 9c and 9d are separated from each other by $P^+$-type channel stopper regions 8a, 8b, 8c, 8d and 8e and field insulator layers 6a, 6b, 6c, 6d and 6e having a large thickness. It should be noted that all of the $P^+$-type channel stopper regions 8a...8e are parts of a continuous region which is formed in a zig-zag or serpentine pattern to allow the charges accumulated in adjacent N-type regions 9a...9d to be taken out in different directions. N-type regions 9a, 9b, 9c and 9d are covered by transparent insulator films 7a, 7b, 7c and 7d. The field insulator layers 6a, 6c, 6c, 6d and 6e and the insulator films 7a, 7b, 7c and 7d are typically made of silicon oxide. The P-type semiconductor substrate 5 and the N-type regions 9a, 9b, 9c and 9d form P-N junctions 10a, 10b, 10c and 10d. Carriers

produced by irradiated light are accumulated in depletion layers caused by these P-N junctions 10a, 10b, 10c and 10d.

In this structure, there are two ways to improve the resolution. One is to increase the number of photosensitive elements, as well as the chip area on which the solid-state image pick-up device is formed. This technique, however, causes a reduction in the production yield as discussed above. The other technique is to increase the number of photosensitive elements while decreasing the area of photosensitive element. Although this technique is most likely to realize an improvement in resolution, it is also characterized by a decrease in sensitivity. Here, it is to be noted that there is a limit to decreasing the width of the $P^+$-type channel stopper regions 8a ~ 8e, because a $P^+$-channel stopper region having a width less than a predetermined value will allow a channel to be formed connecting adjacent N-type regions. Thus, the width of the $P^+$-type channel stopper regions 8a ~ 8e is usually designed to be slightly above this limit. Therefore, increasing the number of photosensitive elements without increasing the occupation area must be accompanied by decrease in the area of the P-N junctions 10a ~ 10d, resulting in the deterioration of sensitivity.

Furthermore, a ratio of the junction area to cell area (where the cell area is the sum of the areas of the junctions 10a ~ 10d and the channel stopper regions 8a ~ 8e), which is a so-called quantum efficiency, would be lowered. This means that the proportion of photo-carriers which are produced under the channel stopper region becomes high and, since most of these photo-carriers are absorbed through recombination without any contribution to the photoelectric conversion, the photoelectric conversion becomes inefficient. Further, some of these photo-carriers are likely to drift to the CCD shift-registers 2a and 2b and the output circuit 4, resulting in a deterioration of the coherence of output with the input light information.

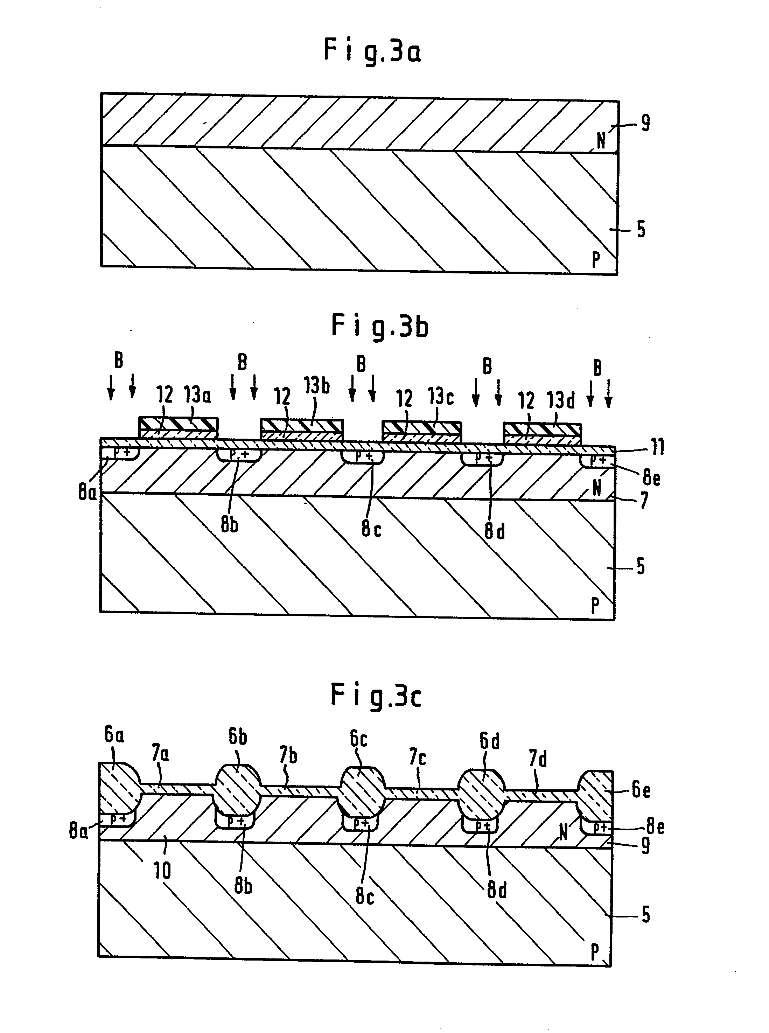

The photosensitive section in a solid state image pick-up device according to the present invention will now be described with reference first to a process for fabricating the section shown in Figs. 3a - 3c.

At first, as shown in Fig. 3a, a semiconductor substrate 5 having an impurity density of about $1 \times 10^{15}$ cm$^{-3}$ is prepared. An ion implanation of phosphorous is effected to the substrate with an energy of 100 KeV and a dose of $1 \times 10^{12}$ cm$^{-2}$. This is followed by an annealing process within a nitrogen atmosphere at $1,100 - 1,200^{\circ}$C to obtain an N-type region 9 having a depth of about $1.5 \mu$m.

Next, as shown in Fig. 3b, an oxide layer 11 having a thick-ness of 500 - 700Å is formed on the N-type region 9, and a silicon nitride layer 12 having a thickness of 1,000Å is formed on the oxide layer 11 by a CVD (Chemical Vapor Deposition) method. After photo-resist layers 13a - 13d each having a predetermined shape are formed on the silicon nitride layer 12, the silicon nitride layer 12 is partly etched away by a plasma etching method using a mask of the photo-resist layers 13a - 13d. This is followed by ion implanation with boron at an energy of 100 KeV and a dose of $1 \times 10^{13}$ cm$^{-3}$ to form P$^{+}$-type channel stopper regions 8a - 8e.

Finally, as shown in Fig. 3c, after the photoresist layers 13a ~ 13d are removed, field oxide layers 6a ~ 6e having a thickness of about 1 μm are formed in a wet oxygen atmosphere at 1,000°C. During this process, the remaining silicon nitride layer 12 operates as a mask for oxidation. This is important in order to retain some thickness of the N-type layer 9 under the $P^+$-type regions 8a ~ 8e whose positions are lowered as a result of the field oxide layer formation. In the following steps, the remaining silicon nitride layer 12 and the oxide layer 11 positioned between $P^+$-type channel stopper regions 8a ~ 8e are removed. Thereafter new gate oxide layers 7a ~ 7d of about 1,000Å are regrown on the surface of the N-type layer 9 between the $P^+$-type channel stopper regions 8a ~ 8e to complete the fabrication. Although the regrowth of the new gate oxide layers 7a ~ 7d may be omitted while instead leaving the oxide layer 11 between the $P^+$-type channel stopper regions 8a ~ 8e, since the oxide layer 11 is contaminated during the manufacturing procedure, it is preferable for the electrical characteristics of the photosensitive section to regrow the new gate oxide layers 7a ~ 7d.

According to this embodiment, the N-type layer 9 exists under the $P^+$-type regions 8a ~ 8e so that the P-N junctions between the N-type region 9 and the substrate 5 exists not only under the gate oxide films 7a-7d but also under the channel stopper regions 8a ~ 8e. Further, since the region 9 is formed under the stopper regions, a P-N junction is also formed between the region 9 and each stopper region 8a-8e. Since each of these additional P-N junctions faces the junction between regions 9 and 5, the potential profile of the N-type region 9 between these facing P-N junctions has a potential well shallower than that of the N-type region 9 between the channel stopper regions 8a ~ 8e so that the regions of layer 9 under the stopper regions 8a-8e act as barrier regions to prevent carriers from drifting between adjacent photosensitive regions under the oxide films 7a-7e. This shallow potential well not operates as a potential barrier preventing photo-carriers produced in the N-type layer 9 between the channel stopper regions 8a ~ 8e from drifting to the adjacent regions, but also improves the sensitivity. More particularly, the photo-carriers produced in the N-type layer 9 under the channel stopper regions 8a ~ 8e drift to the N-type layer 9 between the channel stopper regions 8a ~ 8e which has a deeper potential well, and these are collected, together with the photo-carriers produced in the N-type layer 9, between the channel stopper regions 8a ~ 8e. As a result, the light information irradiated through the channel stopper regions, which is ignored in the photosensitive section in the prior art, is effectively used to improve the sensitivity. Due to this fact, the resolution can be improved, without impairing the sensitivity, by increasing the number of photosensitive elements while decreasing the respective areas thereof. Further, since the number of photosensitive elements may be increased without enlarging the overall area of the semiconductor chip, the production yield of the solid-state image pick-up device is not degraded.

Furthermore, the photo-carriers produced under the channel stoppers 8a ~ 8e are introduced to the N-type layer 9 between the stopper regions without free diffusion.

0075924

Therefore, the photo-carriers do not affect the electrical characteristics of the shift registers 2a and 2b and the output circuit 4 (Fig. 1). Thus, an output faithful to the input light information is obtained.

It is to be noted that, while the present invention has been described above as an embodiment of a linear CCD image pick-up device, this invention can be equally applicable to an area CCD image pick-up device or any type of solid state image pick-up device having a MOS type structure which has a transparent gate electrode on the gate oxide layers 7a ~ 7d of Fig. 3c.

WHAT IS CLAIMED IS:

1. A solid state image pick-up device comprising a semiconductor substrate of one conductivity type, a semiconductor layer formed on said semiconductor substrate, said semiconductor layer including alternating photosensitive regions and barrier regions having a thickness less than said photosensitive regions, an insulator film covering said semiconductor layer, and a further semiconductor region of said one conductivity type formed between said barrier regions of said semiconductor layer and said insulator layer.

2. A solid state image pick-up device as claimed in claim 1, wherein said insulator film has a thickness on said further semiconductor region thicker than on said photosensitive regions of said semiconductor layer.

3. A solid state image pick-up device as claimed in claim 1 or 2, wherein said insulator film is a semiconductor oxide film.

4. A solid state image pick-up device as claimed in claim 1 or 2, further comprising transfer gate means for deriving accumulated charges from said photosensitive regions of said semiconductor layer, a shift register for receiving and shifting said charges from said transfer gate, and an output circuit converting the charges shifted along said shift register into an electrical signal.

5.  A solid state image pick-up device as claimed in claim 4, wherein said transfer gate, said shift register and said output circuit are formed in a single semiconductor substrate.

6.  A solid state image pick-up device as claimed in claim 5, wherein said insulator film is a semiconductor oxide film.

7.  A solid state image pick-up device as claimed in claim 4, wherein said shift register receives said charges from said photosensitive regions in parallel and serially shifts said charges to said output circuit.

8.  A solid state image pick-up device comprising a semiconductor substrate of one conductivity type, a plurality of photosensitive regions of the other conductivity type formed on said semiconductor substrate, and at least one barrier region separating said photosensitive regions from each other, each barrier region including a first semiconductor layer of said other conductivity type formed on said semiconductor substrate and having a thickness thinner than said photosensitive regions and a second semiconductor layer of said one conductivity type formed on said first semiconductor layer.

9.  A solid state image pick-up device as claimed in claim 8, further comprising first insulator films having a first thickness formed on said photosensitive regions, and a second insulator film having a second thickness thicker than said first thickness formed on said second semiconductor

10. A solid state image pick-up device as claimed in claim 9, wherein said first and second insulator films are semiconductor oxide films.

11. A solid state image pick-up device comprising:

a semiconductor substrate of one conductivity type; a semiconductor layer of opposite conductivity type formed on said substrate and having light-receiving regions; and at least one further region of said one conductivity type formed in said semiconductor layer between said light-receiving regions and having a depth less than the thickness of said semiconductor layer whereby said at least one further region does not extend all the way to said substrate and different photosensitive elements are formed in said layer on opposite sides of said at least one further region.

12. A solid state image pick-up device as claimed in claim 11, wherein said semiconductor layer has a first thickness on either side of said at least one further region and a lesser thickness at the location of said at least one further region.

13. A solid state image pick-up device as claimed in claim 11 or 12, further comprising an insulating film covering said semiconductor layer.

Fig.1

Fig.2

Fig.3a

Fig.3b

Fig.3c